# EUROPÄISCHE PATENTSCHRIFT

(11) **EP 1 280 390 B1**
(45) Veröffentlichungstag und Bekanntmachung des Hinweises auf die Patenterteilung: **27.07.2005**
(21) Anmeldenummer: 02015460.5
(22) Anmeldetag: 12.07.2002
(51) Int. Cl.: H05K 1/14

(54) **Elektronischer Schlüssel für Fahrzeuge**
Electronic key for vehicle
Clé électronique pour véhicule

(30) Priorität: 23.07.2001 DE 10134958
(43) Veröffentlichungstag der Anmeldung: 29.01.2003
(73) Patentinhaber: Huf Hülsbeck & Fürst GmbH & Co. KG, 42551 Velbert (DE)
(72) Erfinder: Tensing, Matthias, 50733 Köln (DE)
(74) Vertreter: Mentzel, Norbert, Dipl.-Phys.

(56) Entgegenhaltungen:
- DE-A- 4 321 576
- US-A- 4 939 792
- US-A- 5 434 362

## Beschreibung

Die Erfindung richtet sich auf einen elektronischen Schlüssel der im Oberbegriff des Anspruches 1 angegebenen Art. Ein solcher elektronischer Schlüssel kann fallweise mit einem mechanischen Schlüsselteil versehen sein, der ortsfest oder beweglich am Schlüsselgehäuse sitzt und im letztgenannten Fall daraus herausbewegbar ist, z.B. durch Klappen oder, als sogenannter Notschlüssel, davon lösbar ist, z.B. durch Herausziehen.

Ein bekannter elektronischer Schlüssel dieser Art (DE 39 02 537 C2) umfasst ein zweiteiliges Gehäuse, wo zwischen die beiden Gehäuseteilen eine Leiterplatte gelegt wird, welche unabhängig vom Gehäuse mit den erforderlichen elektrischen und elektronischen Bauteilen bestückt wird. Dazu gehören z.B. Identifikations-Geber und Identifikations-Nehmer, die bei einer Fernbetätigung des Schlüssels die Kommunikation mit entsprechenden stationären Elementen im Fahrzeug aufnehmen, ferner Sende- und Empfangseinheiten, Energiequellen, wie Batterien oder Akkumulatoren und schließlich Schalter und Betätigungselemente, die z.B. aus Tastern bestehen.

Bei elektronischen Schlüsseln ist es auch bekannt, mehrere Platinen im Gehäuse anzuordnen. An wenigstens einem Ende der Platine sind Kontaktstellen angeordnet, auf welche z.B. ein elektrischer Steckverbinder aufgeschoben werden kann, an dem ein Kabel, z.B. ein Flachbandkabel angeschlossen ist. Über dieses Kabel kann dann eine Platine mit einer weiteren Platine verbunden werden.

Von Nachteil ist hierbei, dass die Verbindung der Platinen miteinander über das Kabel zeitaufwendig und anfällig für Fehler ist, weil die Steckverbinder manchmal nicht exakt platziert werden. Auch wenn die bekannte Leiterplatine beidseitig mit Bauelementen versehen wird und die modernen elektrischen Bauteile zunehmend kleiner werden, besteht immer eine Platznot. Die separate Herstellung der Leiterplatine und ihre Bestückung sowie die Montage der Leiterplatine sind zeitaufwendige, umständliche Verfahren, die zur Verteuerung des Produkts führen.

Der Erfindung liegt die Aufgabe zugrunde, einen zuverlässigen elektronischen Schlüssel der im Oberbegriff des Anspruches 1 genannten Art zu entwickeln, der besonders raumsparend und preiswert hergestellt werden kann. Dies wird erfindungsgemäß durch die im Anspruch 1 genannten Maßnahmen erreicht, denen folgende besondere Bedeutung zukommt.

Weil die Innenfläche mindestens des einen Gehäuseteils unmittelbar mit Leiterbahnen versehen ist und bereits Träger von elektrischen Bauteilen ist, wird Platz gewonnen. Das Schlüsselgehäuse lässt sich kleiner bauen. Dieser Gehäuseteil soll nachfolgend kurz "Leiterbahnschale" bezeichnet werden. Die Montage ist vereinfacht, weil über ein Scharnier ein Lappen am Gehäuseteil sitzt, der seinerseits mindestens auf einer Flächenseite mit Leiterbahnen ausgerüstet ist und daher als "Leiterbahnlappen" bezeichnet werden soll. Es liegt eine Baueinheit aus Leiterbahnschale, Leiterbahnlappen und dazwischen liegendem Scharnier vor. Die Bestückung mit elektrischen Bauteilen erfolgt in Aufklapplage der Baueinheit sowohl an der dann bequem zugänglichen Leiterbahnschale, als auch an dem abragenden Leiterbahnlappen. Durch das Scharnier ist die Lage des Leiterbahnlappens nicht nur in der Ausklapplage, sondern vor allem während des Zuklappens und in der Zuklapplage gewährleistet. Leiterbahnen durchsetzen das Scharnier und verbinden damit die an der Leiterbahnschale befindlichen elektrischen Bauteile mit denjenigen, die am Leiterbahnlappen sitzen. Besonders einfach ist der einstückige Aufbau der Baueinheit, wenn das Scharnier als Filmscharnier ausgebildet ist. Die Leiterbahnen werden in der Aufklapplage auf dieser Baueinheit durch die MID-Technik (Moulded Intercontact Devise) hergestellt.

Weitere Maßnahmen und Vorteile der Erfindung ergeben sich aus den Unteransprüchen, der nachfolgenden Beschreibung und den Zeichnungen. In den Zeichnungen ist die Erfindung zwar in einem Ausführungsbeispiel, aber in verschiedenen Stufen seiner Herstellung dargestellt. Es zeigen:
- Fig. 1,: in perspektivischer Darstellung, ein Zwischenprodukt bei der Herstellung des elektronischen Schlüssels, bestehend aus einer besonderen Baueinheit mit zwei zueinander klappbeweglichen Teilen, die sich in ihrer Aufklapplage befinden,
- Fig. 2,: in ebenfalls perspektivischer Darstellung, die Baueinheit von Fig. 1 mit angeformtem mechanischen Schlüsselteil, vor dem Zusammenbau mit der zugehörigen zweiten Gehäusehälfte, und
- Fig. 3: die Seitenansicht des fertig montierten Schlüssels von Fig. 2 mit einem seitlichen Gehäuseausbruch.

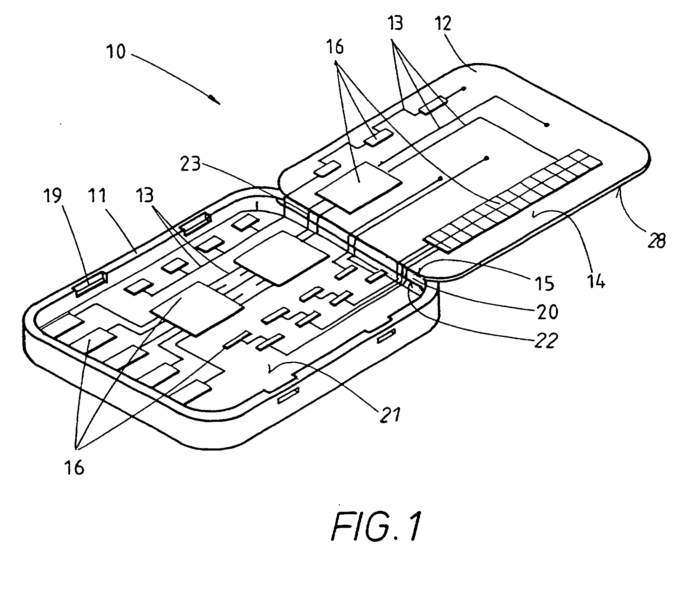

Die Fig. 1 zeigt die Aufklapplage einer besonderen Baueinheit 10, welche aus dem einen Gehäuseteil 11 eines zweiteiligen Gehäuses eines elektronischen Schlüssels und aus einem Lappen 12 besteht. Die Teile 11 und 12 sind miteinander durch ein Filmscharnier 20 verbunden. Mindestens an der einen Flächenseite 14 des Lappens 12 und an der Innenfläche 21 der Gehäusehälfte 11 sind Leiterbahnen 13 angebracht. Einige davon durchqueren auch das Filmscharnier 20, welches die Seitenkante 22 der Gehäusehälfte 11 mit der Seitenkante 15 des Lappens 12 verbindet. Diese Leiterbahnen 13, 23 können nach der bereits erwähnten MID-Technik erzeugt sein. Wegen ihrer Ausrüstung mit elektrischen Leiterbahnen 13 soll der schalenförmige Gehäuseteil 11, wie bereits gesagt wurde, als "Leiterbahnschale" und der Lappen 12 als "Leiterbahnlappen" benannt werden.

An die vorbestimmten Stellen der Leiterbahnen 13, 23 werden die diversen elektrischen und elektronischen Bauteile 16 aufgebracht. Dies erfolgt in der Aufklapplage der Baueinheit 10, gleichzeitig an der Leiterbahnschale 11 und dem Leiterbahnlappen 12.

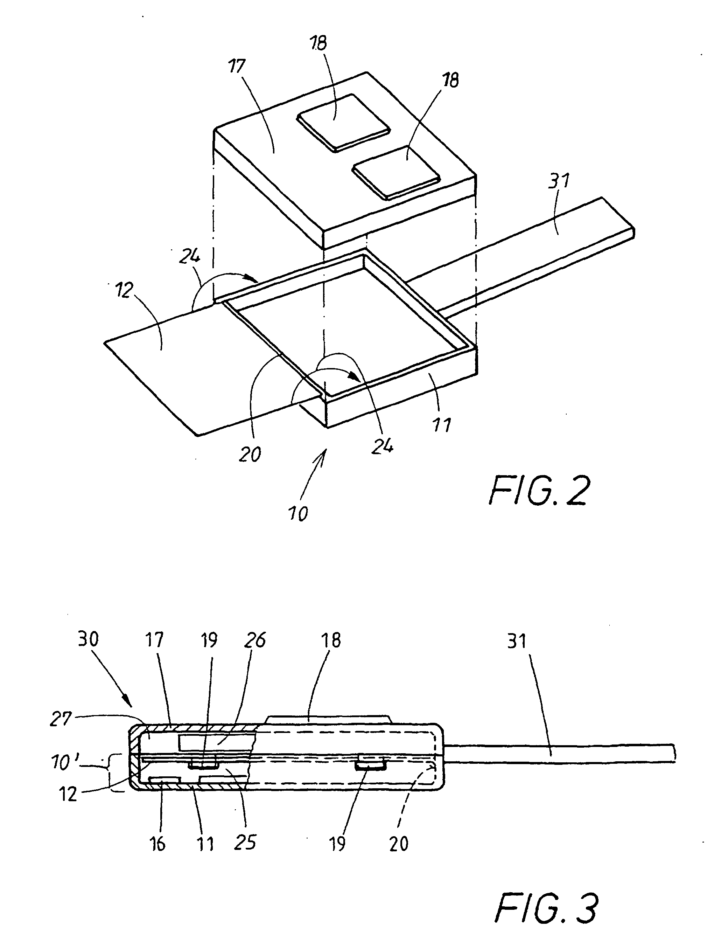

Wie Fig. 2 und 3 verdeutlichen, kann die Leiterbahnschale 11 mit einem mechanischen Schlüsselteil 31 versehen sein. Dieser Schlüsselteil 31 ist im vorliegenden Fall ortsfest an der Leiterbahnschale 11 befestigt, könnte bedarfsweise aber auch davon lösbar sein, oder ganz fehlen. Man kann dabei das Gehäuseinnere zur Aufnahme des mechanischen Schlüsselteils 31 verwenden, so dass der Schlüsselteil 31 dieser im Ruhefall von außen unsichtbar ist. Im Gebrauchsfall kann der Schlüsselteil 31 dann herausgefahren, oder herausgeschwenkt, oder als Notschlüssel entnommen werden. In der Baueinheit 10 von Fig. 2 sind die diversen Leiterbahnen 13 und die Bestückung mit den elektronischen Bauteilen 16 nicht näher gezeigt. Ausweislich der Bewegungspfeile 24 von Fig. 2 kann die Baueinheit 10 zugeklappt werden. Dann ist der Lappen 12 ins Gehäuseinnere eingeklappt und dadurch eine besondere platzsparende Bauweise des elektronischen Schlüssels erreicht. Die Zuklapplage dieser Baueinheit ist in Fig. 3 gezeigt und mit 10' gekennzeichnet.

Wie Fig. 2 veranschaulicht, ist der Baueinheit 10 eine als Gehäusedeckel fungierende zweite Gehäuseteil 17 zugeordnet. Diese kann mit Betätigungselementen, wie Tastern 18, ausgerüstet sein, die in die Deckfläche einstückig integriert sein können. Auf die zugeklappte Baueinheit 10' wird dann der Gehäusedeckel 17 aufgesetzt und mediendicht verbunden. Der Zusammenhalt kann durch Verschlusselemente 19 erfolgen. Es empfiehlt sich jedoch eine Verbindung mittels des sogenannten "Reibschweißens" zu erzeugen, wo die Kanten des zweiten Gehäuseteils 17 einerseits und der Leiterbahnschale 11 andererseits wasserdicht miteinander verbunden werden. Im Inneren des Schlüsselgehäuses befindet sich eine Stromquelle an sich bekannter Art, z.B. ein Akkumulator 26 gemäß Fig. 3. Diese Stromquelle 17 kann im Raum 27 zwischen dem Gehäusedeckel 17 und der zugeklappten Baueinheit 10' positioniert sein. Dafür befinden sich auch auf der Rückseite 28 des Lappens 12 von Fig. 1 nicht näher gezeigte Leiterbahnen, Kontakte und Haltemittel.

### Bezugszeichenliste:

- 10: Baueinheit (Aufklapplage)
- 10': Zuklapplage von 10
- 11: erster Gehäuseteil von 30, Leiterbahnschale
- 12: Lappen an 11, Leiterbahnlappen
- 13: Leiterbahnen von 11 oder 12
- 14: erste Flächenseite von 12
- 15: Seitenkante von 12
- 16: elektronischer bzw. elektrischer Bauteil
- 17: zweiter Gehäuseteil, Gehäusedeckel, Gegengehäuseteil
- 18: Taster
- 19: Verschlussmittel zwischen 10' und 17 (Fig. 3)
- 20: Scharnier, Filmscharnier zwischen 11, 12
- 21: Innenfläche von 11
- 22: Seitenkante von 11 (Fig. 1)
- 23: Leiterbahn auf 20
- 24: Pfeil der Klappbewegung von 20 gegenüber 11 (Fig. 2)
- 25: Gehäuseinneres von 11
- 26: Stromquelle, Akkumulator
- 27: Aufnahmeraum zwischen 10' und 17 (Fig. 3)
- 28: Rückseite von 12

- 30: Funkschlüssel, elektronischer Schlüssel
- 31: mechanischer Schlüsselteil von 30

## Patentansprüche

1. Elektronischer Schlüssel für Fahrzeuge, welcher fallweise einen mechanischen Schlüsselteil (31) aufweist,
mit einem zweiteiligen Gehäuse, welches den etwaigen mechanischen Schlüsselteil (31) trägt oder aufnimmt,
und mit am oder im Gehäuse angeordneten elektrischen und elektronischen Bauteilen (16), die durch Leiterbahnen (13) miteinander verbunden sind,
umfassend einen Identifikations-Geber, Identifikations-Nehmer, Sende- und Empfangseinheiten, elektrische Energiequellen, Schalter und/oder Betätigungselemente,
**dadurch gekennzeichnet,**
**dass** die Innenfläche (21) mindestens des einen schalenförmigen Gehäuseteils (11) mit Leiterbahnen (13) versehen ist und eine Leiterbahnschale (11) bildet, die ein erster Träger der elektrischen Bauteile (16) ist,
**dass** diese Leiterbahnschale (11) über ein Scharnier (20) mit einem ins Gehäuseinnere (25) einklappbaren (24) und herausklappbaren Lappen (12) versehen ist,
welcher mindestens auf seiner einen Flächenseite (14) Leiterbahnen (13) trägt und einen Leiterbahnlappen (13) bildet, der als zweiter Träger der elektrischen Bauteile (16) dient und über das Scharnier (20) mit der Leiterbahnschale (11) eine Baueinheit (10) bildet,
wobei in Aufklapplage der Baueinheit (10) die Leiterbahnschale (11) und der Leiterbahnlappen (12) mit den elektrischen Bauteilen (16) bestückt werden,
und **dass** wenigstens eine der Leiterbahnen (13) auf dem Scharnier (20) angebracht ist und die Leiterbahnen (13) auf der Leiterbahnschale (11) mit denjenigen des Leiterbahnlappens (12) verbindet.

2. Elektronischer Schlüssel nach Anspruch 1, **dadurch gekennzeichnet, dass** die Baueinheit (10) aus der Leiterbahnschale (11), dem Leiterbahnlappen (12) und dem dazwischen liegenden Scharnier (20) einstückig ausgebildet ist.

3. Elektronischer Schlüssel nach Anspruch 1 oder 2, **dadurch gekennzeichnet, dass** das Scharnier der Baueinheit (10) als Filmscharnier (20) ausgebildet ist.

4. Elektronischer Schlüssel nach einem der Ansprüche 1 bis 3, **dadurch gekennzeichnet, dass** die Baueinheit (10) aus der Leiterbahnschale (11), dem Leiterbahnlappen (12) und dem dazwischen liegenden Scharnier (20) aus dem gleichen Kunststoffmaterial besteht.

5. Elektronischer Schlüssel nach einem der Ansprüche 1 bis 4, **dadurch gekennzeichnet, dass** die Leiterbahnen (13) auf der Leiterbahnschale (11), dem Leiterbahnlappen (12) und dem dazwischen liegenden Filmscharnier (20) durch die MID-Technik erzeugt sind.

6. Elektronischer Schlüssel nach einem der Ansprüche 1 bis 5, **dadurch gekennzeichnet, dass** der andere Teil (17) des Gehäuses, nämlich der Gegengehäuseteil, an der zusammengeklappten Baueinheit (10') mediendicht angebracht wird.

7. Elektronischer Schlüssel nach Anspruch 6, **dadurch gekennzeichnet, dass** der Gegengehäuseteil (17) durch Reibschweißen mit der Leiterbahnschale (11) der Baueinheit (10') wasserdicht verbunden ist.

8. Elektronischer Schlüssel nach Anspruch 6 oder 7, **dadurch gekennzeichnet, dass** die beiden Gehäuseteile (11, 17) durch Verschlussmittel (19) miteinander verbunden sind, die eine lösbare Verbindung zwischen der Baueinheit (10') und dem Gegengehäuseteil (17) erzeugen.

9. Elektronischer Schlüssel nach Anspruch 8, **dadurch gekennzeichnet, dass** der eine Teil des Verschlussmittels (17) einstückig mit der Leiterbahnschale (11) der Baueinheit (10) und der andere Teil einstückig mit dem Gegengehäuseteil (17) ausgebildet sind.

## Claims

1. Electronic key for vehicles, which in some cases comprises a mechanical key component (31),
having a two-part housing, which carries or accommodates the mechanical key component (31) if provided,
and having electrical and electronic components (16) arranged on or in the housing, connected to one another by conductors (13),
comprising an identification provider, an identification receiver, transmitting and receiving units, electrical energy sources, switches and/or actuating elements,
**characterised in that**
the inner surface (21) of at least one dish-shaped housing part (11) is provided with conductors (13) and forms a conductor dish (11) which is a first carrier of the electrical components (16),
**in that** this conductor dish (11) is provided, via a hinge (20), with a flap (12) which can be flipped into (24) and out of the interior (25) of the housing,
which carries conductors (13) at least on its flat side (14) and forms a conductor flap (13) which acts as a second carrier of the electrical components (16) and forms a construction unit (10) with the conductor dish (11) via the hinge (20),
while in the flipped open position of the construction unit (10) the conductor dish (11) and the conductor flap (12) are covered with the electrical components (16),
and that at least one of the conductors (13) is mounted on the hinge (20) and connects the conductors (13) on the conductor dish (11) to those of the conductor flap (12).

2. Electronic key according to claim 1, **characterised in that** the construction unit (10) comprising the conductor dish (11), the conductor flap (12) and the hinge (20) between them is formed in one piece.

3. Electronic key according to claim 1 or 2, **characterised in that** the hinge of the construction unit (10) is in the form of a film hinge (20).

4. Electronic key according to one of claims 1 to 3, **characterised in that** the construction unit (10) consists of the conductor dish (11), the conductor flap (12) and the hinge (20) located between them made of the same plastics material.

5. Electronic key according to one of claims 1 to 4, **characterised in that** the conductors (13) on the conductor dish (11), the conductor flap (12) and the film hinge (20) between them are produced by MID Technology.

6. Electronic key according to one of claims 1 to 5, **characterised in that** the other part (17) of the housing, namely the mating housing part, is mounted on the construction unit (10') folded together, so as to be sealed against media.

7. Electronic key according to claim 6, **characterised in that** the mating housing part (17) is connected in water tight manner to the conductor dish (11) of the construction unit (10') by friction welding.

8. Electronic key according to claim 6 or 7, **characterised in that** the two housing parts (11, 17) are joined together by closure means (19) which produce a releasable connection between the construction unit (10') and the mating housing part (17).

9. Electronic key according to claim 8, **characterised in that** one part of the closure means (17) is integrally formed with the conductor dish (11) of the construction unit (10) and the other part is integrally formed with the mating housing part (17).

## Revendications

1. Clé électronique pour véhicules, présentant en cas de besoin, une partie clé (31) mécanique,
avec un boîtier en deux parties, portant ou logeant l'éventuelle partie de clé (31) mécanique,
et avec des composants (16) électriques et électroniques disposés dans le boîtier, reliés ensemble par des pistes conductrices (13),
comprenant un émetteur d'identification, un récepteur d'identification, des unités d'envoi et de réception, des sources d'énergie électriques, des interrupteurs et/ou des éléments d'actionnement,
**caractérisée en ce que**
la face intérieure (21) d'au moins une partie de boîtier (11) en forme de coque est munie de pistes conductrices (13) et forme une coque à pistes conductrices (11) constituant un premier support des composants électriques (16),
**en ce que** cette coque à pistes conductrices (11) est munie de languettes (12) susceptibles d'être introduites par rabattement (24) à l'intérieur du boîtier (25) et d'être sorties par rabattement, par l'intermédiaire d'une charnière (20),
qui, au moins sur l'une de ses faces plates (14), porte des pistes conductrices (13) et forme une languette à pistes conductrices (13), servant de deuxième support aux composants électriques (16) et formant, par l'intermédiaire de la charnière (20), un ensemble de construction (10) avec la coque à pistes conductrices (11),
sachant que, en position ouverte par rabattement de l'ensemble de construction (10), la coque à pistes conductrices (11) et les languettes de pistes conductrices (12) sont munies des composants électriques (16),
et **en ce qu'**au moins l'une des pistes conductrices (13) est appliquée sur la charnière (20), et les pistes conductrices (13) se trouvant sur la coque de bande de conducteur (11) sont reliées à celles de la languette de bande conductrice (12).

2. Clé électronique selon la revendication 1, **caractérisée en ce que** l'ensemble de construction (10) est formé, d'une seule pièce, de la coque à pistes conductrices (11), des languettes de pistes conductrices (12), et de la charnière (20) intermédiaire.

3. Clé électronique selon la revendication 1 ou 2, **caractérisée en ce que** la charnière de l'ensemble de construction (10) est conformée en charnière-film (20).

4. Clé électronique selon l'une des revendications 1 à 3, **caractérisée en ce que** l'ensemble de construction (10), formé de la coque à pistes conductrices (11), des languettes de pistes conductrices (12), et de la charnière (20) intermédiaire, est formé du même matériau synthétique.

5. Clé électronique selon l'une des revendications 1 à 4, **caractérisée en ce que** les pistes conductrices (13) situées sur la coque à pistes conductrices (11), les pistes conductrices (12) et la charnière-film (20) intermédiaire, sont produites par la technique MID (Moulded Intercontact Devise).

6. Clé électronique selon l'une des revendications 1 à 5, **caractérisée en ce que** l'autre partie (17) du boîtier, précisément à la partie de boîtier conjuguée, est montée, de façon étanche aux fluides, sur l'ensemble de construction (10') rassemblé par rabattement.

7. Clé électronique selon la revendication 6, **caractérisée en ce que** la partie de boîtier conjuguée (17) est reliée, de façon étanche à l'eau, par soudure par friction, à la coque à pistes conductrices (11) de l'ensemble de construction (10').

8. Clé électronique selon la revendication 6 ou 7, **caractérisée en ce que** les deux parties de boîtier (11, 17) sont reliées ensemble par des moyens de fermeture (19), produisant une liaison désolidarisable entre l'ensemble de construction (10') et la partie de boîtier conjuguée (17).

9. Clé électronique selon la revendication 8, **caractérisée en ce qu'**une partie des moyens de fermeture (17) est réalisée d'une seule pièce avec la coque à pistes conductrices (11) de l'ensemble de construction (10), et l'autre partie est réalisée d'une seule pièce avec la partie à boîtier conjuguée (17).
